# EUROPEAN PATENT APPLICATION

(11) **EP 3 211 124 A1**
(43) Date of publication of application: **30.08.2017**
(21) Application number: 15784406.9
(22) Date of filing: 18.09.2015
(51) Int. Cl.: C25B 1/04, C25B 15/02, C25B 15/08, H01L 31/0256, H01L 29/16, H01M 8/0656

(54) **ENERGY GENERATION SYSTEM WITH HYDROGEN FUEL CELL-BASED GENERATION SOURCE**

(30) Priority: 22.09.2014 ES 201431375
(71) Applicant: Antequera Rodríguez, Nicolás, 28903 Getafe (Madrid) (ES); Rossell Barranco, Enrique, 8008 Zurich (CH)
(72) Inventor: RUEDA ARÉVALO, Francisco Javier, 28903 Getafe (Madrid) (ES)
(74) Representative: Capitán García, Maria Nuria
(86) International application number: PCT/ES2015/070679
(87) International publication number: WO 2016/046434

(57) **Abstract**

System comprising an element for capturing and transforming external light into electricity based on the use of doped graphene; an electricity management control board to which are connected: a battery and a generator for supplying the current needed by a hydrolysis machine connected to the generator; a hydrogen tank connected to the hydrolysis machine; an oxygen tank connected to the hydrolysis machine, for use in space-based systems, which can be vented through an exhaust; a fuel cell or hydrogen cell connected to the hydrogen and oxygen tanks and a water deposit connected on one side to the hydrogen cell from which it receives the water generated and on the other to the hydrolysis machine to which it supplies the water. A self-sufficient or autonomous generation system is achieved.

## Description

### TECHNICAL FIELD OF THE INVENTION

The present invention relates to a power generation system based on hydrogen generation using a solar source to generate the energy needed to obtain hydrogen and oxygen from water by electrolysis. The hydrogen generated is the secondary power source used in a hydrogen cell to generate the electricity that will be used when needed.

The invention is characterised by the synergy obtained from combining electricity generation means that use high-efficiency graphene sheets, the use of energy storage cells, and a generator for supplying power and performing a hydrolysis process from which to obtain hydrogen and oxygen, which are stored in tanks and supplied to a fuel cell that generates energy and water from the hydrogen and oxygen; the water is then stored in a tank from where energy is supplied to the hydrolysis machine, thereby obtaining a power generation system that does not require an external power or fuel supply for a long time, which can thus be described as a self-sufficient or autonomous generator system as it can generate the energy consumed from the energy captured by the graphene sheets.

The present invention therefore belongs to the field of power generation systems, specifically systems using hydrogen and oxygen fuel cells.

### BACKGROUND OF THE INVENTION

Several types of systems that generate electricity from hydrogen are known. Among these are the following.
- The most common one is that used by recharging hydrogen in specific tanks which the hydrogen cell later uses to generate electricity or drive an electric motor.
- Also known is the use of solar panels in small-scale vehicles where the hydrogen is generated and used by the hydrogen cell to drive an electric motor.
- The use of electric batteries to drive electric motors directly or operate other electrical devices without any additional power source is known.

All of the aforementioned systems present drawbacks or aspects that can be improved. In the case of generator systems with fuel cells that use hydrogen stored in tanks, the autonomy will depend on the volume of the hydrogen storage tanks, requiring the hydrogen tanks to be periodically replaced with full tanks.

For solar panels used in combination with fuel cells, the generation capacity is greatly limited by the low efficiency of the solar panels, as well as the need to replace the water that is used. The generation capacity is low, such that this is impractical as a drive means or autonomous generation method for vehicles and the like.

If electrical batteries are used as the power supply means for driving the vehicle, the limitation is given by the battery storage capacity; in addition, the batteries must be recharged periodically, resulting in a complex system.

Consequently, the aim of the present invention is to provide a system for power generation that overcomes the aforementioned drawbacks of lack of autonomy and generation capacity, developing a system such as that described below, the essence of which is given in claim one.

### DESCRIPTION OF THE INVENTION

The present invention relates to an electricity generation system for use in various power consumption devices, and specifically for ground, air and water transportation, where the system itself generates the energy required without needing supplies from a third party where the recycling of the raw material is its main value.

The system comprises several power generation elements, an equal number of motion generation elements and as many regeneration elements.

The power generation system with a generation source based on a hydrogen cell comprises:
- A main generation system based on the use of a doped graphene sheet.
- Secondary electricity generation elements based on electricity generation from hydrogen that allow generating electricity without the need for the main generation system using batteries or an external power source.

The power generation system comprises:
- An element for capturing and transforming external light into electricity using one or several sheets of doped graphene.
- An electricity management station control board connected to the light capture and transformation element, to which are connected:
   ▪ A backup battery,
   ▪ A generator used to supply the current needed by a hydrolysis machine.
- The hydrolysis machine which connected to the generator receives power from the generator.
- A hydrogen tank connected to the hydrolysis machine.
- An oxygen tank connected to the hydrolysis machine that is used in space-based systems, which can be vented to the exterior through an exhaust outlet.
- A fuel cell or hydrogen cell connected to the hydrogen and oxygen tanks.
- A water tank connected on one side to the hydrogen cell, from which it receives the generated water, and to the hydrolysis machine, to which it supplies the water.

The element for capturing electric light and transforming it into electricity comprises a doped graphene layer, or similar elements available in the future, with impurities that provide an efficiency of about 60%, compared to a solar cell with an efficiency of only approximately 15%. This graphene compound is transparent and has a flexible structure, and can be placed on any other surface preserving the aesthetic appearance thereof. The hardness of this layer is 200 times greater than steel, so that installation on any surface, given its adaptation, is useful even to preserve the properties of the surface that is covered. This photoconducting element can be adhered to any surface, on rooftops, vehicles, etc. and is the source of the main electrical power that drives all the secondary electrical systems, that is:
- Water electrolysis system.
- Hydrogen pressure pumps.
- H₂O recovery and supply pumps.
- Electrical system.

This layer, initial generator and basis of the subject matter of the patent, will generate sufficient electrical power, currently in illumination conditions. The evolution of the art will allow generating electrical energy in light frequency conditions other than the visible spectrum, such as infra-red and ultraviolet.

Graphene is currently an active field of research, for which numerous functionalities are being found already described in the relevant technical/scientific literature. The electrical properties thereof as well as the possibility of electron generation by photovoltaic processes are in profound and constant evolution towards an ideal material for use in the body of transportation systems due to the small thickness thereof, as well as for other surfaces where it is necessary to generate electricity, presenting outstanding light capture and adaptation to the various designs of vehicle bodies or surfaces in general.

### Secondary electricity generation elements

This system for electricity generation from hydrogen comprises the following elements that allow generating electricity without requiring the main element, two auxiliary systems allowing generation without having to use the main element:
- Low capacity electrical batteries.
- External electrical power source via an overhead connection.

The electricity control board receives as input the main light capture element based on doped graphene and supplies current to two element, a backup battery and a generator. It can also supply current directly to the final element, that is, a vehicle, building or any other element that must be powered electrically.

The backup battery is used only to generate the electricity needed for the aforementioned electrical generation control board.

The generator is used to supply the necessary current for the hydrolysis machine.

The hydrolysis machine separates the hydrogen and oxygen, which are transported to the corresponding H and O tanks. This hydrolysis machine is different from current hydrolysis technology in that it needs very little power to separate the H and O elements, which makes the system feasible from a technical and commercial point of view by allowing very small dimensions for the entire system as well as very small power consumption. The hydrolysis machine has a power consumption of only 5 watt.

The hydrogen tank is very small, preventing explosion risks, thereby ensuring the safety of this system in any situation. This tank is connected to a conventional hydrogen cell that generates the electricity needed for consumption.

In addition an oxygen tank is connected between the hydrolysis machine and the hydrogen cell, in the same way as for the aforementioned hydrogen tank. This oxygen tank is not relevant when the system is used on Earth, but is essential for providing oxygen in systems designed to operate in space.

Finally, the system has a water tank connected to the hydrogen cell. This tank allows water feedback to the hydrolysis machine, such that the electricity generation process can be independent of the main element based on doped graphene for a considerable length of time.

### Hydrolysis machine

The water electrolysis system generates the hydrogen needed as a power source for generating the electrical energy, whether for the motor of a transport system or for general consumption.

This electrolysis system uses water as its main and only source. This exclusive source model prevents the need to refill chemical additives and therefore eliminates regeneration costs and potentially polluting emissions outside of the circuit, providing at the same time an efficient and non-polluting model.

The water electrolysis device for generating hydrogen comprises a set of elements arranged in parallel/series allowing enough hydrogen to be generated to supply a local hydrogen tank, sized to amply fulfil the needs of the rated power of the hydrogen cell. In this way, in the case of a vehicle, it will be possible to travel 400 Km without any assistance other than the content of the tank.

The photovoltaic graphene element supplies electricity to the electrolysis system through the generator connected to the electrical management control board. This energy triggers the reaction needed to break down water into oxygen, which is emitted to the atmosphere or used in situations where required, and hydrogen, which is compressed in the tank by a pump.

The electrolysis element is formed y a series of elements described in the figures.

### Hydrogen storage system

A pressure pump is used to collect all the hydrogen generated in the electrolysis process and store it at a maximum pressure of 12 atmospheres in the main tank.

This tank supplies the hydrogen cell, where the required electricity will be generated.

In a practical embodiment of the invention, the electricity generation system based on a hydrogen cell is a closed system known as a generation cell that consists of the elements described above. To generate 1 MW, the generation cell has a volume of 1 cubic metre. Installing the electricity generation cells in series will allow obtaining higher power, and the cells connected in series can be controlled by a central electronic element that allows adapting the required power according to the actual consumption at any time by activating or deactivating the corresponding cells. Since the generation cell also produces heat in the process, it can also be used to provide heat for buildings, water, etc.

Throughout the description and claims the term "comprises" and the various forms thereof are not meant to exclude other techniques, additives, components or steps. A person skilled in the art will recognise that other objects, advantages and features of the invention follow in part from the description and in part from the field of the invention. The following examples and drawings are provided by way of example and are not meant to limit the present invention. Moreover, the present invention covers all possible combinations of specific and preferred embodiments described herein.

### BRIEF DESCRIPTION OF THE DRAWINGS

To complete the description being made, and in order to aid a better understanding of the characteristics of the invention, according to an example of a preferred embodiment thereof, a set of drawings are provided that form an integral part of this description where, for purposes of illustration and in a non-limiting sense, the following is shown:

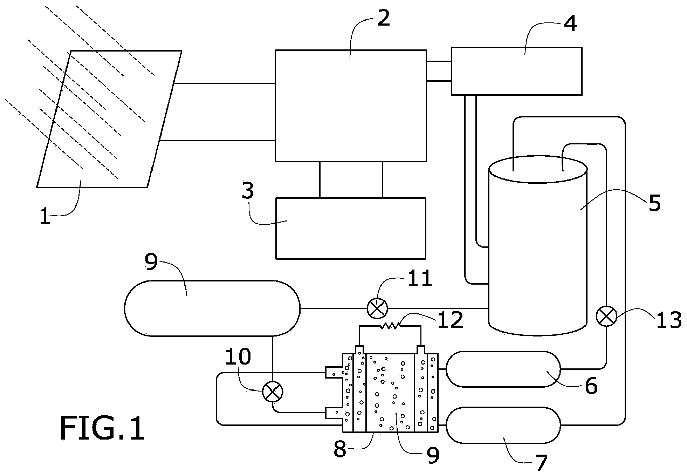

Figure 1 shows a schematic representation of an example of the generation system with a generation source based on a hydrogen cell.

### DETAILED DESCRIPTION OF THE PREFERRED EMBODIMENT OF THE INVENTION

In view of the figures, a preferred embodiment of the proposed invention is described below.

Figure 1 shows that the generation system :
- An element for capturing light from the outside and transforming it into electricity based on the use of a doped graphene layer (1).
- An electricity management control board (2) connected to the light capture and transformation element, to which are connected:
   ▪ A backup batter (3).
   ▪ A generator (4) used to supply the current needed by a hydrolysis machine (5).
- The hydrolysis machine (5) which when connected to the generator receives the power from the generator.
- A hydrogen tank (6) connected to the hydrolysis machine by a hydrogen pressure pump (13).
- An oxygen tank (7) connected to the hydrolysis machine for use in space-based systems, wherein the oxygen can be released to the exterior through an exhaust.
- A fuel cell or hydrogen cell (8) that is connected to the hydrogen (6) and oxygen (7) tanks.
- A water tank (9) connected on one side to the hydrogen cell (8) by a water recovery pump (10) that allows transferring the water generated to the water tank (9), which in turn is connected to the hydrolysis machine (5) through a water supply pump (11) to which the water is supplied.

The hydrogen cell (8) is in charge of generating the power that will be used by a vehicle motor, the power systems used in a building, etc.

The power generation system of the invention has numerous possibilities; in addition to the usual materials used in vehicles for which this technology can be used, the following elements can be added specifically.

### Power generators.

Vehicle body. Photoconducting graphene sheets are attached to the body by sheets fitted against the structure of the vehicle, forming a transparent and highly resistant layer. A protective film is placed on this layer.

Each sheet is wired concentrating at a single point where the power generated is supplied to the various consumers (power control board).

In case of accident or damage to the vehicle, it is only necessary to replace the new part. As each sheet is independent, damages do not compromise the energy efficiency.

Electric motors. In vehicles with more than one electric motor, these motors can be arranged such that the motors not used for traction use the motion to generate electricity used in the generation of hydrogen electrolysis.

Secondary or backup accumulators. The vehicle is equipped with a backup accumulator that allows said vehicle to generate during a certain time the power required for the electrolysis process and supply power to the low-consumption electrical elements.

The energy accumulated is that generated by the body, and, in the case of electrical polymotors, by the motors in a suitable configuration.

### Electricity consumers.

### Hydrogen generator.

The water electrolysis system comprises various elements. These are:
- Frequency generator
- Electrolysis generator
- Hydrogen manifold
- Oxygen manifold
- Hydrogen tank
- Oxygen tank

### Frequency generator.

A low-voltage frequency generator provides the power needed to dissociate water molecules into H and O.

When the high-efficiency electrolysis system is used there is no need for a high voltage, as the Planck formula E = f * h, where E is the energy required, f is the frequency at which the bonds break in the H₂O molecule and h is a constant, applies.

The device operates in the range of subharmonics to avoid consuming power. This allows a sufficiently high photovoltaic efficiency.

### Electrolysis generator.

Hydrogen is generated in a hermetically sealed tank. The device comprises a number of chambers separated by about 3 mm from each other, where each face has an electrode. These chambers are also used as separation areas where H is produced in odd-numbered chambers and O is produced in even-numbered chambers. No electrolytes are used in the model.

Each odd-numbered cavity is provided on its top part with a channelled orifice in which the generated hydrogen is grouped. This channel has a pressure pump connected to the power distribution core for power supply, and operates at a fixed pressure of 12 atmospheres, which is the pressure of the hydrogen tank.

Depending on the power generated by the vehicle, as many hydrogen generators will be needed as litres/hour are necessary for a correct operation of the main generator

Each hydrogen generator has a minimum production capacity of 8 to 12 litres of H per hour.

Even-numbered cavities have an orifice identical to that described above, also connected to a central manifold.

### Hydrogen manifold.

The manifold joins all the hydrogen generator units. In its final sector the manifold narrows, generating a Venturi effect and facilitating the task of the pressure pump.

The manifold as a whole is formed by sealed elements that prevent gas leaks and is made of plastic elements that do not generate electricity. At the end thereof, before the tank also made of anti-static and sealed plastic, a pump is installed to increase the pressure to 12 atmospheres and reduce the space needed to store the hydrogen. The tank volume does not need to be larger than 40 litres.

The pump is powered by the energy generated by the graphene-based photovoltaic system, and is one of the consumption elements.

### Oxygen manifold

The oxygen is also introduced in ducts but it is not stored. All the gas generated is emitted to the exterior by an appropriate exhaust. This is the only emission produced by the entire system.

In space-based systems the oxygen is also led to a tank where it is stored for subsequent use as a mixing element in the hydrogen cell. The storage process is similar to that for hydrogen.

### Hydrogen tank

The hydrogen tank stores hydrogen in a safe and risk-free manner, and is large enough to store enough gas to provide sufficient range in paths without sunlight.

It is made of a high-resistant and anti-static plastic material and is the main element for supply to the hydrogen cell(s).

The tank has a number of optical and mechanical sensors that activate the electrolysis process on demand. That is, the vehicle does not generate hydrogen unless the hydrogen is used to under 80% capacity.

### Oxygen tank

Identical to the hydrogen tank in the cases described above when it is needed.

### Drive generator

The vehicle drive system operates using the hydrogen cell. This technique uses the electricity generated by consuming hydrogen.

The system can have as many hydrogen cells in series as needed for the electrical demand required.

The end product of this reaction is water (H₂O), which is treated in a subsequent stage.

### Motion generator

The system comprises one or several electric motors depending on the power requirements.

### Single motor

In these cases the motor is placed at a specific place in the vehicle and transmits its force by a drive management system or gearbox and differential gears.

### Two motors

In these cases the drive system is placed in each of the shafts and controlled by a digital control board described in the electronics section.

The system in general can use one or both motors; if one is disabled it can be used to generate electricity independent of motion.

### Four motors.

A complex system controlled by a digital control board. One motor is used for each drive element (for each wheel in vehicles with four wheels). The power is controlled by a digital control board that manages the electric potential that must be received and the revolutions according to the driving conditions.

Similarly to the previous case, if any motor is disabled as a drive element it can be used to generate power.

### Drive system

The system generates the energy needed to power the main drive unit of the vehicle using one or several hydrogen cells.

The drive systems are as follows:
- Singe motor. A single electric motor providing the necessary motion.
- Dual motor (land vehicles). Drives the front or rear torque of the vehicle and is controlled by a digital control board (other vehicles depending on the drive specifications thereof).
- Four motors (land vehicle). Drives each of the wheels (other vehicles depending on the drive specifications thereof).

In the last two cases (land vehicles) the power of the motors will be twice the rated power. This allows the system to work with different driving traction conditions selected.

### Traction and control.

Vehicles with a single motor have direct drive controlled by a system, when necessary a gearbox. Vehicles with more than one motor have traction controlled by a digital switchboard that manages the power of each motor and the desired traction.

### All-wheel, front or rear drive.

In vehicles without all-wheel drive the power generated by the motors is used in the electrolysis process and for the electricity required by the electrical components.

Having sufficiently described the nature of the present invention and the embodiment thereof, it is noted that without departing from the essence thereof other embodiments are possible differing in details from that given by way of example, which will also be included in the scope of protection sought provided the main principle of the invention is not altered, changed or modified.

## Claims

**1.** Power generation system with generation source based on a fuel cell, **characterised by** comprising:
- An element for capturing light from the outside and transforming it into electricity based on the use of a doped graphene layer (1).
- An electricity management control board (2) connected to the light capture and transformation element, to which are connected:
▪ A backup batter (3).
▪ A generator (4) used to supply the current needed by a hydrolysis machine (5).
- The hydrolysis machine (5) which when connected to the generator receives the power from the generator.
- A hydrogen tank (6) connected to the hydrolysis machine by a hydrogen pressure pump (13).
- A fuel cell or hydrogen cell (8) connected to the hydrogen (6) and oxygen (7) tanks.
- A water tank (9) connected on one side to the hydrogen cell (8) by a water recovery pump (10) that allows transferring the water generated to the water tank (9), which in turn is connected to the hydrolysis machine (5) through a water supply pump (11) to which the water is supplied.

**2.** Power generation system with generation source based on a fuel cell according to claim 1, **characterised by** also comprising an oxygen tank (7) connected to the hydrolysis machine.

**3.** Power generation system with generation source based on a fuel cell according to claim 1, **characterised in that** the hydrolysis machine comprises:
- A frequency generator;
- An electrolysis generator;
- A hydrogen manifold;
- An oxygen manifold.

**4.** Power generation system with generation source based on a fuel cell according to claim 1, **characterised in that** the frequency generator is a low-voltage frequency generator operating in the sub-harmonic range.

**5.** Power generation system with generation source based on a fuel cell according to claim 1, **characterised in that** the electrolysis generator is a sealed tank comprising a series of chambers separated about 3 mm from each other where each one of the faces thereof has an electrode. These chambers are also used as separator areas where hydrogen is produced in the odd-numbered chambers and oxygen is produced in the even-numbered chambers.

**6.** Power generation system with generation source based on a fuel cell according to claim 5, **characterised in that** odd-numbered cavities are provided on the top part thereof with a channelled orifice or central manifold where all the hydrogen generated is grouped, this channel being provided with a pressure pump connected to the power distribution core for power supply and operating at a fixed pressure of 12 atmospheres.

**7.** Power generation system with generation source based on a fuel cell according to claim 5, **characterised in that** even-numbered cavities are provided on the top part thereof with an orifice similar to that described above and also connected to a central manifold.

**8.** Power generation system with generation source based on a fuel cell according to claim 6, **characterised in that** the hydrogen manifold connects all the hydrogen generator units and in the final segment thereof narrows to generate a Venturi effect, is formed by sealed elements that prevent gas leaks and is made from plastic components that do not generate electricity.

**9.** Power generation system with generation source based on a fuel cell according to claim 6, **characterised in that** the oxygen manifold is also channelled and where the oxygen is not stored but instead vented through an exhaust.

**9.** Power generation system with generation source based on a fuel cell according to claim 1, **characterised in that** the hydrogen tank is made of a high-resistance and anti-static plastic material.
includes a series of optical and mechanical sensors that activate the electrolysis process on demand.

**10.** A vehicle powered by the power generation system of any of the preceding claims, **characterised in that** it comprises one, two or four motors.
